Europäisches Patentamt

European Patent Office

Office européen des brevets

(19)

(11) Publication number: **0 430 493 A2**

## (12) EUROPEAN PATENT APPLICATION

(21) Application number: **90312438.6**

(22) Date of filing: **15.11.90**

(51) Int. Cl.⁵: **H03L 7/00, H03J 5/02**

(30) Priority: **27.11.89 JP 308414/89**

(43) Date of publication of application:
**05.06.91 Bulletin 91/23**

(84) Designated Contracting States:
**CH DE GB LI**

(71) Applicant: **SEIKO INSTRUMENTS INC.**
**31-1, Kameido 6-chome Koto-ku**
**Tokyo 136 (JP)**

(72) Inventor: **Hirotomi, Jun, c/o Seiko Instruments**
**Inc.**
**31-1 Kameido 6-chome**
**Koto-ku, Tokyo (JP)**

(74) Representative: **Caro, William Egerton et al**
**J. MILLER & CO. Lincoln House 296-302 High**
**Holborn**
**London WC1V 7JH (GB)**

(54) **Signal processor.**

㊾ The present invention provides a signal processor having data supply means (4, 5) for providing data signals, and control means (2) responsive to a control voltage (Vin) for providing a control current (I), the current control means being arranged to co-operate with the data supply means so as selectively to vary the rate of change of the control current with the control voltage according to the content of the data signals, and current control type oscillation means (1) for receiving the control current and supplying a corresponding output frequency.

# FIG. 1

EP 0 430 493 A2

## SIGNAL PROCESSOR

The present invention relates to a signal processor for supplying an output frequency according to a control voltage.

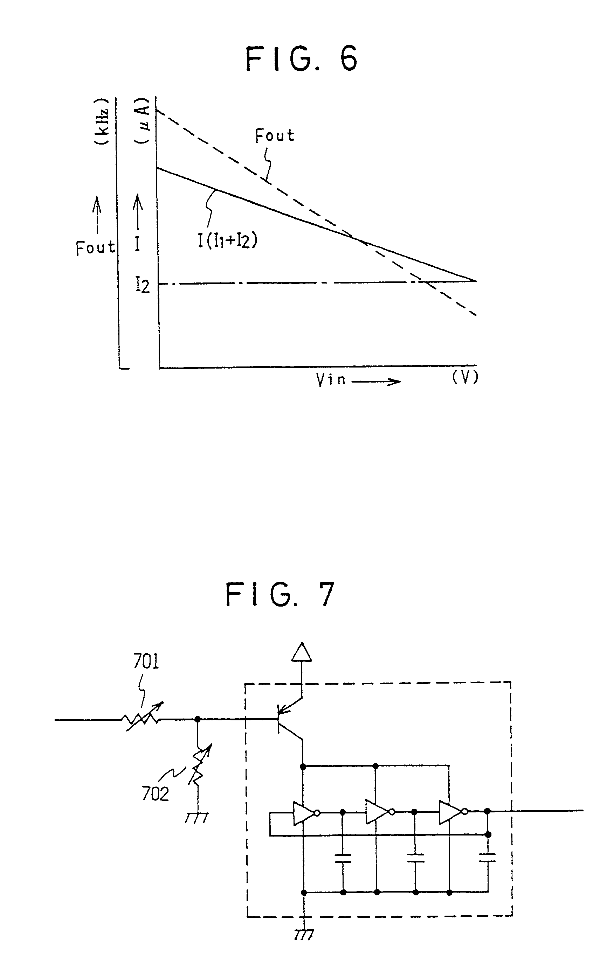

In order to adjust the absolute value of the output frequency and the rate of change of the output frequency with respect to the control voltage in a prior art voltage control type oscillator, volume resistors 701 and 702 as shown in Figure 7 may be adjusted or the element itself may be exchanged.

In a conventional voltage control type oscillator, such volume resistors have a size of $5 \times 5 \times 2$ mm at the minimum. On the other hand, a resistor element has a size of about $2 \times 3 \times 1$ mm. Therefore, these components may be unable to be mounted in a small sized device, such as a wrist watch, in which a packaging area for electric components is limited. Moreover, the exchange of an element is very difficult.

It is an object of the present invention to provide a signal processor for supplying an output frequency according to a control voltage, in which the above problems are avoided.

According to the present invention, there is provided a signal processor characterised by data supply means for providing data signals, current control means responsive to a control voltage for providing a control current, the current control means being arranged to co-operate with the data supply means so as selectively to vary the rate of change of the control current with the control voltage according to the content of the data signals, and current control type oscillation means for receiving the control current and supplying a corresponding output frequency.

In the present invention, the output frequency may be varied without the need for the volume resistors employed in the prior art and so it is possible to reduce the physical dimensions of the circuitry substantially.

According to the invention, current control type oscillation means and current control means for varying the rate of change of a control current with a control voltage in accordance with supplied electric information are combined to make it possible to set output frequency characteristics at will in relation to the control voltage without the need for any external element, and to assemble the components onto a single chip.

The invention is described further, by way of example, with reference to the accompanying drawings, in which :—

Figure 1 is a functional block diagram showing an embodiment of a signal processor according to the present invention ;

Figure 2 is a circuit diagram showing details of an example of the signal processor of Figure 1 employing MOS transistors ;

Figure 3 is a diagram showing the relation between current and frequency in current control type oscillation means of the signal processor of Figure 2 ;

Figure 4 is a diagram showing the relation between voltage and current in first current control means of the signal processor of Figure 2 ;

Figure 5 is a diagram showing the relation between voltage and current in second current control means of the signal processor of Figure 2 ;

Figure 6 is a diagram showing the relation between control voltage and current, and control voltage and frequency in the signal processor of Figure 2 ; and

Figure 7 is a circuit diagram showing a prior art voltage control type oscillation circuit.

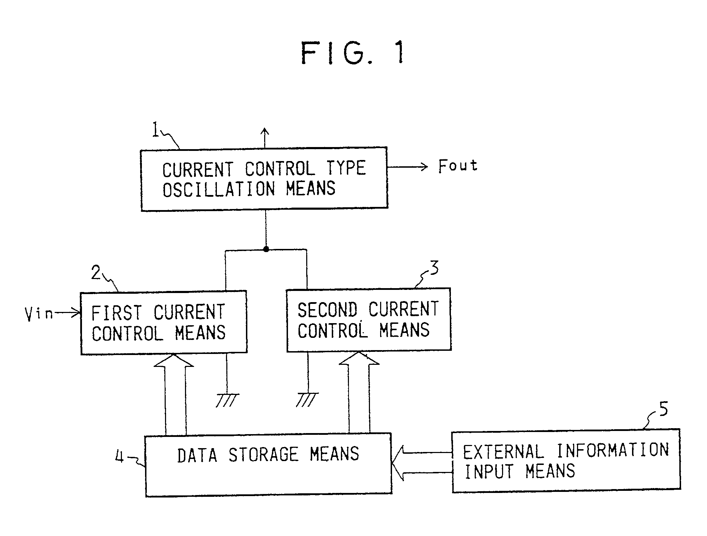

Figure 1 is a functional block diagram showing an embodiment of the present invention having current control type oscillation means 1 for providing an output frequency Fout, which is variable in accordance with an input electric control current. The current control type oscillation means 1 is fed with the control current from first current control means 2 and second current control means 3. The first current control means 2 varies its output control current in accordance with an external control voltage Vin, and further alters the rate of change of the output control current with respect to the control voltage on the basis of data stored in data storage means 4. On the other hand, the second current control means 3 supplies an output control current in accordance with data stored in the aforementioned data storage means 4. External information input means 5 are connected to this data storage means 4 for inputting data.

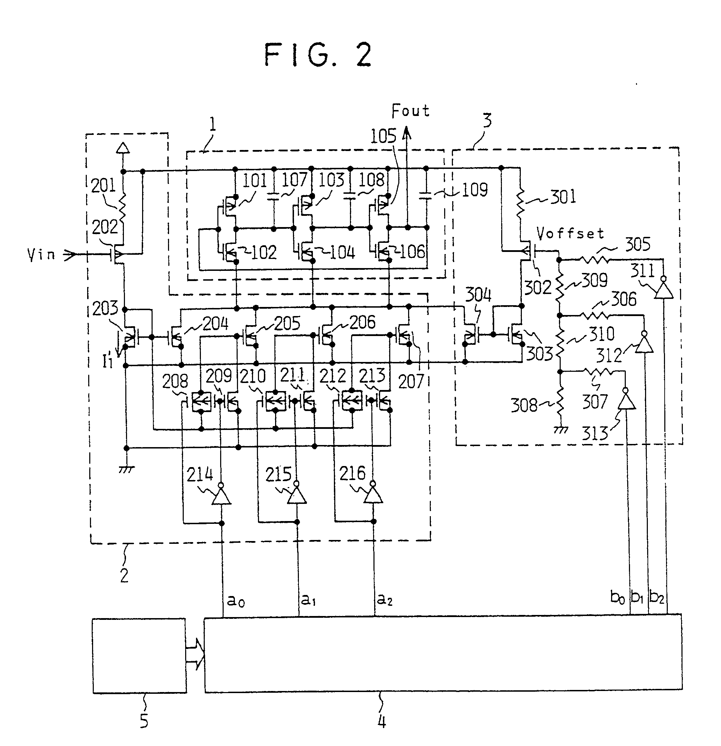

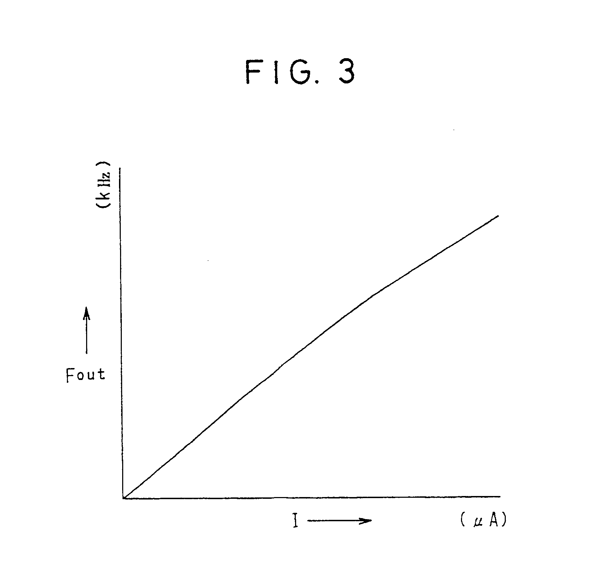

Figure 2 is a circuit diagram showing specific details of an example of the above embodiment, employing MOS transistors. The current-frequency characteristic of the current control type oscillation means 1 are shown in Figure 3. The current supplied to the aforementioned current control type oscillation means 1 is controlled both by N-type transistors 204 to 207 of the first current control means 2 and by an N-type transistor 304 of the second current control means 3 so as to provide as output the frequency Fout which is dependent on the current.

A transistor 203, arranged in a saturated manner, is connected to the transistors 204 to 207 so as to constitute a current mirror circuit together with the transistors 204 to 207. If the transistors 204 to 207 have a threshold voltage $V_T$ equal to that of the transistor 203, the current flow in the transistor 204 is expressed by

$(K204 / K203) \times I_{TR}$

where $I_{TR}$ expresses the current flow in the transistor 203, and Kn expresses the K-value of a transistor $\underline{n}$.

Likewise, currents of

(K205 / K203) × $I_{TR}$, (K206 / K203) × $I_{TR}$ and (K207 / K203) × $I_{TR}$

will flow through the transistors 205 to 207. If the current supplied by the transistors 204 to 207 is generally represented by $I_1$, this current $I_1$ can be expressed as follows :

$$I_1 = I_{TR} \times (K204 + K205 + K206 + K207) / K203 \quad (1)$$

The transistors 205 to 207 are fed with gate signals through analog switches 208, 210 and 212. When these analog switches 208, 210 and 212 are turned OFF, analog switches 209, 211 and 213 also connected to the gates of the transistors 205 to 207 are turned ON, and the gate voltages of the individual transistors 205 to 207 drop to 0 V so that no current will flow. In other words, whether or not current flows through each of the transistors 205 to 207 can be controlled in accordance with electric signals $a_0$, $a_1$ and $a_2$ supplied from the data storage means 4 directly to the analog switches 208, 210 and 212, and by way of inverters 214, 215 and 216 to the analog switches 209, 211 and 213. The transistors 205 to 207 are turned ON for $a_0$ to $a_2$ = 1 and OFF for $a_0$ to $a_2$ = 0.

Hence, the Equation (1) can be expressed in the following form :

$$I_1 = I_{TR} \times (K204 + a_0 \times K205 + a_1 \times K206 + a_2 \times K207) / K203 \quad (2)$$

Let it here be assumed that the individual K values be as follows :

K203 = 100, K204 = 25, K205 = 25, K206 = 50, and K207 = 100 [$\mu A/V^2$].

In this case, the following equation may be obtained from Equation (2) :

$$I_1 = I_{TR} \times (1 + a_0 + 2a_1 + 4a_2) / 4 \quad (3)$$

The value $I_1$ takes its minimum of $I_{1min} = 0.25\, I_{TR}$ for $a_0$ to $a_2$ = 0, and its maximum of $I_{1max} = 2\, I_{TR}$ for $a_0$ to $a_2$ = 1. In other words, the value $I_1$ can be arbitrarily set in accordance with the values $a_0$ to $a_2$.

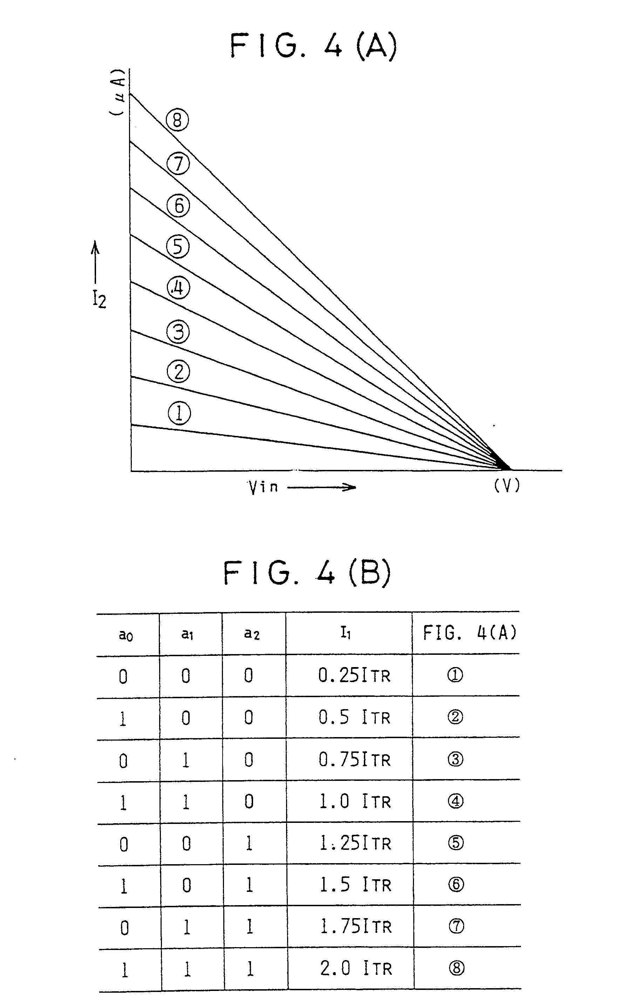

Figure 4 (A) shows the relation between the voltage Vin and the current $I_1$ supplied by the first current control means, and Figure 4 (B) shows the relations between $a_0$ to $a_2$ and $I_1$.

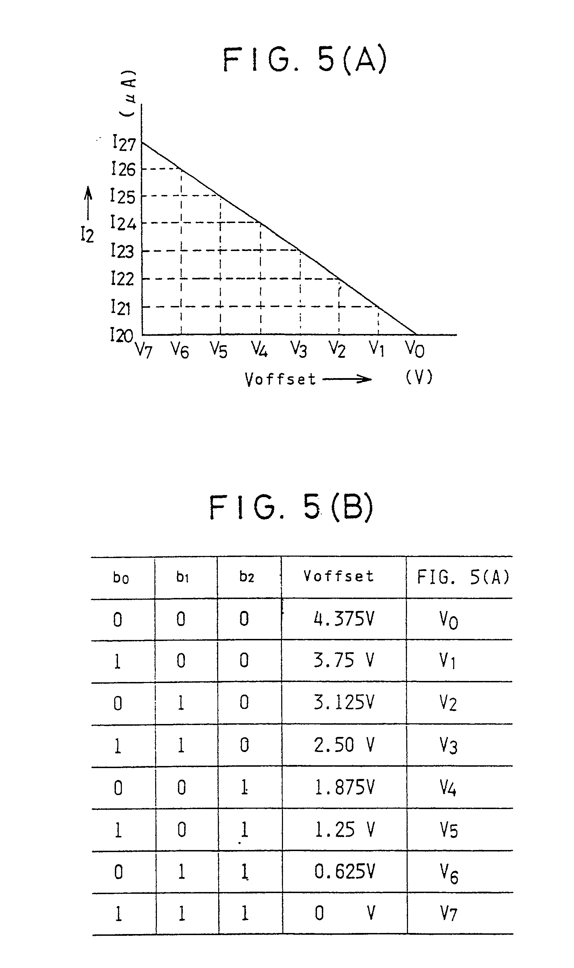

The fundamental operation of the second current control means 3 is identical with that of the aforementioned first current control means 2. The relation between an off-set voltage Voffset and a current $I_2$ flowing through the transistor 304 is plotted in Figure 5 (A). The off-set voltage Voffset is determined according to the values of electric signals $b_0$ to $b_2$ supplied by the data storage means 4 through inverters 311 to 313 by way of resistors 305 to 310. The resistors 309 and 310 have an equal resistance, and the resistors 305 to 308 also have an equal resistance, which is two times that of the resistors 309 and 310. The relations between the values $b_0$ to $b_2$ and the voltage Voffset for $V_{DD}$ = 5 V and GND = 0 V are shown in Figure 5 (B).

Since the off-set voltage Voffset is determined in dependence upon the values $b_0$ to $b_2$, the current $I_2$ flowing through the transistor 304 is automatically determined.

Since the current I supplied to the aforementioned current control type oscillation means 1 is ($I_1$ + $I_2$), the frequency characteristic of the output Fout of the current control type oscillation means 1 can be changed in dependence upon the values $a_0$ to $a_2$ and $b_0$ to $b_2$. Figure 6 shows the characteristics Vin and Fout and Vin — I after the first current control means and the second current control means have been selectively adjusted.

The current control type oscillation means 1, the data storage means 4, the first current control means 2 and the second current control means 3 are preferably formed from semi-conductor components, for example made from silicon compounds or the like, on a common substrate.

According to the present invention, the output characteristics of a voltage control type oscillator off-set from a standard can be digitally adjusted both in gradient and off-set frequency without exchanging volume resistors or elements.

## Claims

1. A signal processor characterised by data supply means (4, 5) for providing data signals, current control means (2) responsive to a control voltage (Vin) for providing a control current (I), the current control means being arranged to co-operate with the data supply means so as selectively to vary the rate of change of the control current with the control voltage according to the content of the data signals, and current control type oscillation means (1) for receiving the control current and supplying a corresponding output frequency (Fout).

2. A signal processor according to claim 1 characterised in that the data supply means comprise data storage means (4) for storing data, and external information input means (5) for the input of information to the data storage means.

3. A signal processor according to claim 1 or 2 characterised in that the current control means comprise a voltage-current converter (203).

4. A signal processor according to claim 3 characterised in that the current control means comprise a plurality of current limiters (204 to 207) connected to the voltage-current converter.

5. A signal processor according to claim 4 characterised in that the current control means comprise switching means (208 to 213) responsive to the data signals for controlling the current limiters.

6. A signal processor according to any preceding claim characterised by further current control means (3) arranged to co-operate with the data supply means so as selectively to vary the base level of the control current according to the content of the data signals.

7. A signal processor according to claim 6 characterised in that the further current control means comprise means (305 to 310) for providing an off-set voltage (Voffset) for determining the base level of the control current, and means (311 to 313) operable in response to the data signals for selectively adjusting the off-set voltage.

8. A signal processor according to any preceding claim characterised in that the data supply means, the current control means, and the current control type oscillation means are formed from semi-conductor components on a common substrate.

9. A signal processor characterised by current control type oscillation means (1) having its output frequency changing with an electric current, data storage means (4) for storing and holding an electric signal, external information input means (5) for inputting electric signal information to said data storage means, first current control means (2) for changing the changing rate of the electric current, which is held in said data storage means, to a control voltage, and second current control means (3) for feeding an electric current according to the electric signal which is held in said data storage means.

# FIG. 1

1

CURRENT CONTROL TYPE
OSCILLATION MEANS → Fout

2

Vin → FIRST CURRENT
CONTROL MEANS

3

SECOND CURRENT
CONTROL MEANS

5

DATA STORAGE MEANS ← EXTERNAL INFORMATION
INPUT MEANS

4

EP 0 430 493 A2

# FIG. 2

# FIG. 3

# F I G. 4 (A)

# F I G. 4 (B)

| $a_0$ | $a_1$ | $a_2$ | $I_1$ | FIG. 4(A) |
|---|---|---|---|---|
| 0 | 0 | 0 | 0.25$I_{TR}$ | ① |
| 1 | 0 | 0 | 0.5 $I_{TR}$ | ② |
| 0 | 1 | 0 | 0.75$I_{TR}$ | ③ |
| 1 | 1 | 0 | 1.0 $I_{TR}$ | ④ |
| 0 | 0 | 1 | 1.25$I_{TR}$ | ⑤ |
| 1 | 0 | 1 | 1.5 $I_{TR}$ | ⑥ |
| 0 | 1 | 1 | 1.75$I_{TR}$ | ⑦ |
| 1 | 1 | 1 | 2.0 $I_{TR}$ | ⑧ |

# FIG. 5(A)

# FIG. 5(B)

| b0 | b1 | b2 | Voffset | FIG. 5(A) |
|----|----|----|---------|-----------|
| 0 | 0 | 0 | 4.375V | V0 |
| 1 | 0 | 0 | 3.75 V | V1 |
| 0 | 1 | 0 | 3.125V | V2 |
| 1 | 1 | 0 | 2.50 V | V3 |
| 0 | 0 | 1 | 1.875V | V4 |
| 1 | 0 | 1 | 1.25 V | V5 |
| 0 | 1 | 1 | 0.625V | V6 |
| 1 | 1 | 1 | 0  V | V7 |

9

# F I G. 6

# F I G. 7